Europäisches Patentamt

European Patent Office

Office européen des brevets

(11) Veröffentlichungsnummer: **0 142 826**
**B1**

(12) **EUROPÄISCHE PATENTSCHRIFT**

(45) Veröffentlichungstag der Patentschrift: **25.04.90**

(51) Int. Cl.⁵: **H 03 L 1/02**

(21) Anmeldenummer: **84113831.6**

(22) Anmeldetag: **15.11.84**

(54) **Anordnung zur Stabilisierung der von einem Frequenzgenerator, insbesondere einem Quarzgenerator, abgegebenen Frequenz.**

(30) Priorität: **18.11.83 DE 3341780**
**19.04.84 DE 3414955**
**15.05.84 DE 3418004**
**15.05.84 DE 3418003**

(43) Veröffentlichungstag der Anmeldung:
**29.05.85 Patentblatt 85/22**

(45) Bekanntmachung des Hinweises auf die
Patenterteilung:
**25.04.90 Patentblatt 90/17**

(84) Benannte Vertragsstaaten:
**AT BE CH DE FR GB IT LI NL SE**

(56) Entgegenhaltungen:
**EP-A-0 083 303**
**FR-A-2 148 920**
**FR-A-2 410 909**
**US-A-4 297 657**

**ALTA FREQUENZA, Band 51, Nr. 1, Januar-Februar 1982, Seiten 43-48, Milano, IT; G. BOLLE et al.: "Stable frequency and low power consumption quartz oscillator"**

(73) Patentinhaber: **Siemens Aktiengesellschaft**
**Wittelsbacherplatz 2**
**D-8000 München 2 (DE)**

(72) Erfinder: **Niethammer, Dieter, Ing. (grad)**
**Zugspitzstrasse 34**
**D-8011 Putzbrunn (DE)**

## Beschreibung

Die Erfindung betrifft eine Anordnung zur Stabilisierung der von einem Frequenzgenerator, insbesondere einem Quarzgenerator, abgegebenen Frequenz, mit einer die frequenzbestimmenden Elemente dieses Frequenzgenerators auf einer vorgegebenen Temperatur haltenden Thermostatanordnung, welche aus einem die frequenzbestimmenden Elemente aufnehmenden Thermostatgehäuse und einem die Innentemperatur dieses Thermostatgehäuses regelnden Temperaturregler besteht, der ein Heizelement und einen als temperaturabhängigen Hilfsoszillator ausgebildeten Temperatur-Sensor aufweist, dessen Frequenz für die Bereitstellung einer dem Heizelement zuzuführenden Stellgröße herangezogen ist, wobei die frequenzbestimmenden Elemente des Hilfsoszillators ebenfalls in dem Thermostatgehäuse aufgenommen sind und wobei die Temperaturabhängigkeit des Frequenzgenerators und des Hilfsoszillators zumindest innerhalb eines vorgegebenen Temperaturbereiches derart unterschiedlich ist, daß sich bei der gewünschten Frequenz des Frequenzgenerators ein stabiler Arbeitspunkt des aus dem Frequenzgenerator, dem Hilfsoszillator und dem Heizelement bestehenden ersten Regelkreises einstellt.

Solche Anordnungen werden insbesondere für Taktversorgungseinrichtungen synchroner Daten- und Nachrichtennetze benötigt. Die dort verwendeten Oszillatoren sollen eine hohe Eigengenauigkeit besitzen und sich mit Hilfe von Regelschaltungen auf externe Referenzfrequenzen synchronisieren lassen. Die verlangten Genauigkeitswerte haben eine konstante Umgebungstemperatur für die frequenzbestimmenden Elemente zur Voraussetzung. Es ist üblich, diese konstante Umgebungstemperatur durch Thermostatbetrieb herzustellen. Falls das frequenzbestimmende Element ein Schwingquarz ist, muß die Betriebstemperatur so gewählt sein, daß sie im Bereich des sogenannten Umkehrpunktes des Quarzes liegt bzw. es muß ein Schwingquarz gewählt werden, dessen Umkehrpunkt bei einer Temperatur liegt, die sich mit Rücksicht auf die zu erwartende Umgebungstemperatur durch Regelung leicht konstant halten läßt.

Es ist üblich, Schwingquarze und Oszillatorschaltungen innerhalb eines Thermostatgehäuses anzuordnen, dessen Innentemperatur mit Hilfe einer elektrischen Verlustleistungsregelung konstant gehalten wird. Zur Temperaturregelung werden u. a. analog arbeitende Regelschaltungen (Proportionalregler) und Temperaturmeßfühler (z. B. Kaltleiter, Heißleiter) verwendet, die justiert und an den erwähnten Umkehrpunkt des Quarzes angepaßt werden mussen.

Darüber hinaus ist bereits eine Anordnung der eingangs genannten Art zur Stabilisierung der von einem Frequenzgenerator abgegebenen Frequenz bekannt (FR-A-2 410 909). Bei dieser bekannten Anordnung ist ein Schwingquarz vorgesehen, der sowohl in einem C-Modus als auch in einem B-Modus schwingen kann. Dabei besteht zwischen den beiden Modi ein im wesentlichen festes Frequenzverhältnis, welches lediglich durch eine stärkere Temperaturabhängigkeit im B-Modus in vorgegebenen Grenzen variieren kann. Die Frequenzen in den beiden Modi werden durch gesonderte Filteranordnungen selektiert. Anhand dieser beiden Frequenzen wird dann mit Hilfe einer Auswerteeinrichtung eine Stellgröße für ein Heizelement abgeleitet.

Bei der bekannten Anordnung ist durch die Verwendung des in zwei Modi schwingenden Quarzes die Frequenz des Hilfskreises (B-Modus) nicht regelbar. Diese Frequenz ist durch die Frequenz im C-Modus festgelegt. Bei einer vorgegebenen Arbeitstemperatur und einer vorgegebenen Arbeitsfrequenz des Quarzes (C-Modus) stellt sich somit durch den bei dieser bekannten Anordnung vorgesehenen Regelkreis ein Arbeitspunkt ein, der durch den Hilfskreis (B-Modus des Quarzes) nicht optimierbar ist.

Außerdem ist bereits eine Resonatoranordnung für die Bereitstellung eines temperaturkompensierten Zeitnormals bekannt (EP-A-0083 303). Bei dieser Resonatoranordnung sind zwei gesonderte Quarzoszillatoren vorgesehen. Ein erster Quarzoszillator, der das Zeitnormal bereitstellt, weist eine temperaturabhängige Kennlinie mit einem Umkehrpunkt auf. Der zweite Quarzoszillator dient als Temperatursensor und weist eine linear von der Temperatur abhängige Kennlinie auf. Die Kennlinie des zweiten Quarzoszillators soll dabei die Kennlinie des ersten Quarzoszillators in deren Umkehrpunkt durchlaufen. Die von den beiden Quarzoszillatoren abgegebenen Frequenzen werden zunächst einer Anordnung zur Ermittlung der Frequenzdifferenz zugeführt. Nach Maßgabe dieser Frequenzdifferenz, die ein Maß für die Temperatur darstellt, wird anschließend ein Signal erzeugt, um die Frequenz des ersten Quarzoszillators zu regeln.

Der Erfindung liegt nun die Aufgabe zugrunde, eine Anordnung der eingangs genannten Art so auszubilden, daß der Arbeitspunkt des aus dem Frequenzgenerator, dem Hilfsoszillator und dem Heizelement bestehenden ersten Regelkreises optimal eingestellt werden kann.

Gelöst wird diese Aufgabe bei einer Anordnung der eingangs genannten Art erfindungsgemäß dadurch, daß der Hilfsoszillator in einen ersten Phasenregelkreis einbezogen ist, durch welchen die Frequenz des Hilfsoszillators im Zuge eines Eichvorganges durch Zuführen einer entsprechenden Abgleichgröße nach Maßgabe einer Bezugsfrequenz auf den stabilen Arbeitspunkt des ersten Regelkreises regelbar ist.

Die Erfindung bringt einerseits den Vorteil mit sich, daß sich eine vorgegebene bzw. geforderte Genauigkeit der Temperaturregelung und damit der Frequenzstabilität einfacher erreichen läßt als mit zuvor genannten Temperaturmeßfühlern, die eine manuelle Justierung erfordern, da bei der Anordnung gemäß der Erfindung die im Thermostatgehäuse wirksame Temperatur nicht an den Temperaturverlauf irgendeines analogen Bauelementes, sondern an eine Bezugsfrequenz gekoppelt ist, die mit großer Genauigkeit zur Verfügung steht. Mit der Anordnung gemäß der vorliegenden Erfindung ist innerhalb einer mehrere Stunden umfassenden Zeitspanne eine Frequenzkonstanz von $10^{-10}$ erreichbar, während bei herkömmlichen Frequenzgeneratoren mit Temperaturmeßfühlern maximal eine Frequenzkonstanz von $10^{-9}$ erzielt werden kann. Andererseits besteht der Vorteil der vorliegenden Erfindung gegenüber der aus der FR-A-2 410 909 bekannten Anordnung darin, daß die Frequenz des Hilfsoszillators mit einfachen schaltungstechnischen Mitteln auf den stabilen Arbeitspunkt des ersten Regelkreises optimal regelbar ist.

Vorteilhafte Ausgestaltungen und Weiterbildungen der Erfindung ergeben sich aus den Unteransprüchen.

Im folgenden wird die Erfindung anhand von Zeichnungen beispielsweise näher beschrieben.

FIG. 1 zeigt in einem Blockschaltbild einen Frequenzgenerator, bei dem die Erfindung angewandt ist,

FIG. 2 zeigt ein detaillierteres Blockschaltbild des in FIG 1 dargestellten Frequenzgenerators,

FIG. 3 zeigt eine weitere Ausführungsform des für die Frequenzstabilisierung vorgesehenen Heizelements und der mit diesem verbundenen Vergleicherschaltung,

FIG. 4 zeigt ein Prinzipschaltbild der in FIG 2 dargestellten Rücksetzschaltung.

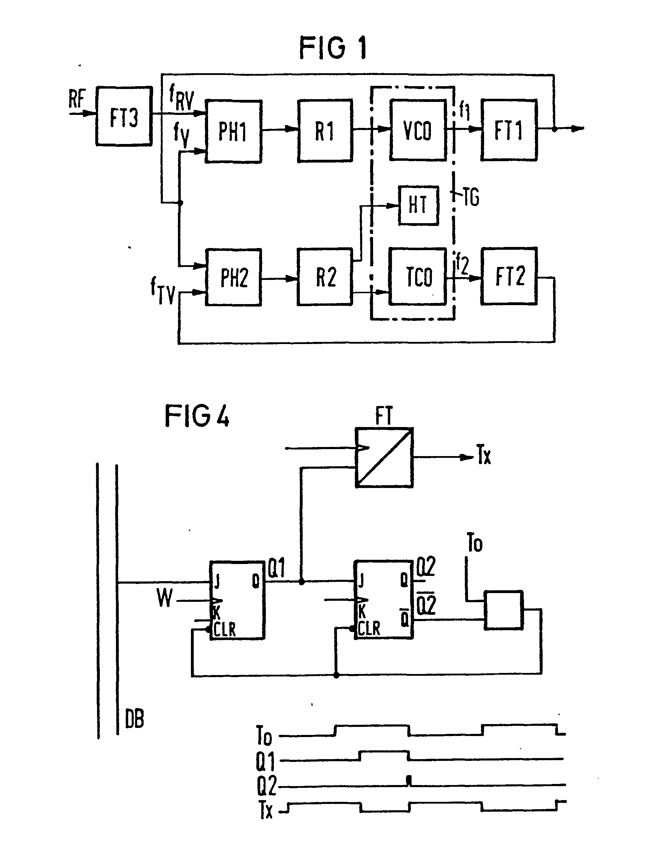

In FIG. 1 ist ein Frequenzgenerator dargestellt, der eingangsseitig ein Signal mit einer Referenzfrequenz RF zugeführt erhält. Aus dieser Referenzfrequenz wird mit Hilfe eines Frequenzteilers FT3 eine interne Vergleichsfrequenz $f_{RV}$ gewonnen, die ein Phasendiskriminator PH1 mit einer weiteren, aus der Ausgangsfrequenz des Frequenzgenerators durch Frequenzteilung in einem Frequenzteiler FT1 gewonnenen Vergleichsfrequenz $f_V$ vergleicht. Die bei diesem Vergleich ermittelte Phasendifferenz wird in dem Phasendiskriminator digitalisiert und als binäre Zahlengröße an einen Phasenregler R1 übergeben, der bei dem hier beschriebenen Ausführungsbeispiel aus einem Mikroprozessor gebildet ist. Dieser Phasenregler ermittelt aus der Phasendifferenz eine Stellgröße, welche sich aus Proportional- und Integralanteil zusammensetzt. Diese Stellgröße wird in einen Spannungswert umgesetzt, der mit Hilfe einer Varaktordiode, die im Resonanzkreis eines zu einem Quzarzoszillator VCO gehörenden Schwingquarzes liegt, die Frequenz des Quarzoszillators steuert. Der gerade erwähnte Schwingquarz, dessen Temperaturabhängigkeit kubisch verläuft, wird dabei im oberen Temperaturumkehrpunkt betrieben. Im Idealfall ist der Temperaturkoeffizient in diesem punkt gleich Null. Der Strom durch den Schwingquarz-Resonanzkreis wird dabei auf einen für Präzisionsoszillatoren erforderlichen kleinen Wert geregelt. Um die Temperatur des Schwingquarzes konstant zu halten, ist dieser in einem Thermostatgehäuse TG untergebracht. Da die übrigen Komponenten der Oszillatorschaltung ebenfalls nennenswerte Temperaturkoeffizienten aufweisen, sind auch diese innerhalb des Thermostatgehäuses angeordnet. Der Schwingquarz ist dabei direkt mit dem Gehäuse verbunden, um einen guten thermischen Kontakt zu erreichen.

Das Thermostatgehäuse TG besteht aus einem metallischen Gehäuse mit konstanter Innentemperatur. Dieses Gehäuse weist eine gegenüber der Umluft isolierende Ummantelung auf. Diese Ummantelung des Thermostatoehäuses gegenüber der Umluft bewirkt eine Verminderung von Störeinflüssen durch die Umgebung und eine Reduzierung der Betriebsleistung. Das Gehäuse selbst ist dabei aus Metall mit guter thermischer Leitfähigkeit und großer spezifischer Wärmekapazität heroestellt. Dadurch werden Temperaturunterschiede innerhalb des Gehäuses klein gehalten.

Das Thermostatgehäuse TG ist zusammen mit dem Temperaturregler Bestandteil einer Thermostatanordnung. Dieser Temperaturregler weist als Temperatur-Sensor einen temperaturabhängigen Hilfsoszillator TCO auf, dessen temperaturabhängiges Element aus einem Temperatur-Meßquarz gebildet ist. Dieser Temperatur-Meßquarz ist zusammen mit einem Heiztransistor HT, der ebenfalls Bestandteil des Temperaturreglers ist, in dem genannten Thermostatgehäuse angeordnet. Der Temperaturkoeffizient des Temperatur-Meßquarzes ist im übrigen annähernd konstant und relativ hoch gegenüber dem Temperaturkoeffizienten eines normalen Schwingquarzes. Damit verläuft die Temperaturabhängigkeit der Frequenz des Hilfsoszillators in einem vorgegebenen Temperaturbereich monoton bzw. annähernd linear.

Die aufgrund der Innentemperatur des Thermostatgehäuses sich einstellende Frequenz $f_2$ des Hilfsoszillators TCO wird mit Hilfe eines Frequenzteilers FT2 um einen vorgegebenen Betrag heruntergeteilt ($f_{TV}$) und in einem Phasendiskriminator PH2 mit einer Normalfrequenz $f_V$ verglichen. Bei dieser Normalfrequenz handelt es sich um die mit Hilfe des Frequenzteilers FT1 um einen vorgegebenen Betrag verminderte Frequenz des Quarzoszillators VCO. Aus der bei diesem Vergleich sich ergebenden Phasendifferenz ermittelt ein Temperaturregler R2 mit PI-Verhalten den Proportionalund Integralanteil für eine Stellgröße, die die Leistung des Heiztransistors HT steuert, der sich in dem bereits erwähnten Thermostatgehäuse befindet.

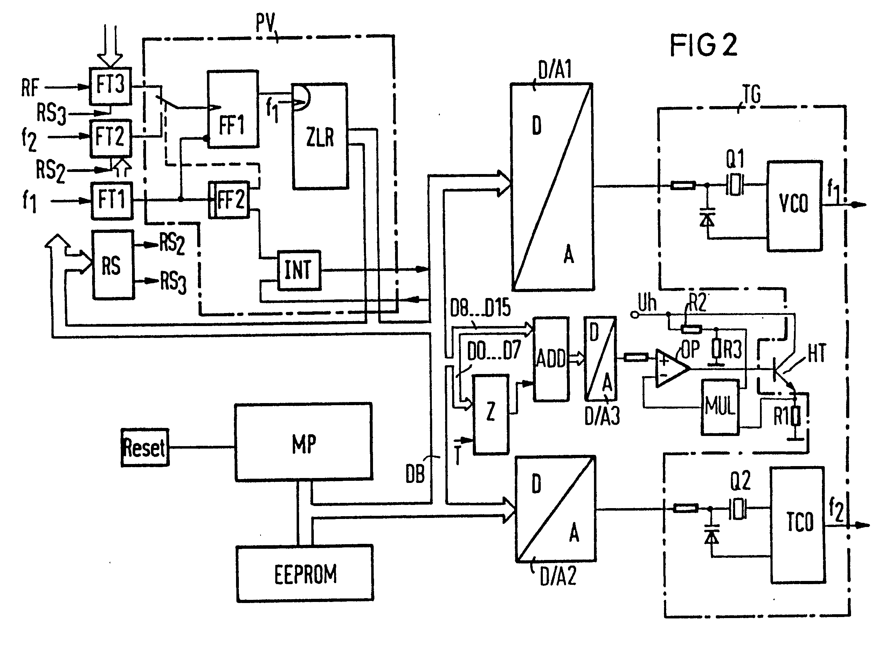

In Fig. 2 ist der gerade erläuterte Frequenzgenerator detaillierter dargestellt. Hierbei ist anstelle der in Fig. 1 angegebenen Phasendiskriminatoren PH1 und PH2 lediglich ein einziger Phasenvergleicher PV vorgesehen. Dieser Phasenvergleicher wird im Multiplex-Betrieb ausgenutzt. Hierfür ist der Phasenvergleicher mit den Frequenzteilern FT2 und FT3 eingangsseitig verbunden. Die von diesen Frequenzteilern abgegebenen Frequenzsignale werden abwechselnd dem Takteingang einer Kippstufe FF1 zugeführt. Ein Signaleingang dieser Kippstufe ist mit dem Ausgang des Frequenzteilers FT1 verbunden. Das von diesem Frequenzteiler abgegebene Frequenzsignal wird außerdem einer weiteren Kippstufe FF2 zugeführt. Am Ausgang der Kippstufe FF1 tritt ein binäres Signal mit einem der Phasendifferenz der Eingangssignale proportionalen Impulsverhältnis auf. Während eines der beiden Zustände dieses binären Signals wird ein mit dem Frequenzsignal $f_1$ beaufschlagter Takteingang eines der Kippstufe FF1 nachgeschalteten Zählers ZLR freigegeben. Am Ende der Meßperiode entspricht der Zählerstand dieses Zählers dem Binärwert des quantisierten Phasendifferenzsignals. Eine Unterbrechungsschaltung INT veranlaßt einen Mikroprozessor MP, den Zählerstand des Zählers ZLR zu lesen. Dieser Mikroprozessor realisiert sowohl die Funktion des in Fig. 1 dargestellten Phasenreglers R1 als auch die des in Fig. 1 dargestellten Temperaturreglers R2.

Die bereits erwähnte Kippstufe FF2, die über einen ihrer Ausgänge mit der Unterbrechungsschaltung INT verbunden ist, steuert über einen weiteren Ausgang den Multiplex-Betrieb des Phasenvergleichers PV. Diese Kippstufe bewirkt dabei, daß der Phasenvergleicher abwechselnd die von den Frequenzteilern FT2 und FT3 abgegebenen Frequenzsignale übernimmt und daß der Mikroprozessor MP über eine Meldeleitung ein Unterbrechungssignal für die Übernahme des Zählerstandes des Zählers ZLR zugeführt erhält. Der Mikroprozessor ist im übrigen mit dem Phasenvergleicher für die Übernahme der Unterbrechungssignale bzw. der von dem Zähler ZLR bereitgestellten Zählerstände über einen aus 16 Einzelleitungen bestehenden Datenbus DB verbunden.

Der Mikroprozessor MP realisiert die Funktion des Phasenreglers RI in der Weise, daß er aus dem ihm von dem Phasenvergleicher PV her zugeführten Zählerstand, der ein Maß für die aufgetretene Phasendifferenz ist, den Proportional- und den Integralanteil ermittelt und die Summe dieser beiden Anteile als Stellgröße abgibt. Die Koeffizienten, die die Zeitkonstanten des Reglers mit PI-Verhalten bestimmen, sind variabel. Sie werden nach einem adaptiven Verfahren während des Betriebes ermittelt und eingestellt. Hierfür dienen als Kriterium die phasendifferenz und die Frequenzabweichung, die in Toleranzbereiche eingeteilt sind. Bei Ausfall der Referenzfrequenz RF bleibt der zuletzt errechnete Integralwert gespeichert und wird als Stellgröße ausgegeben. Falls erforderlich, kompensiert der Mikroprozessor MP auch die nichtlineare Frequenzsteuerkennlinie der bereits genannten Varaktordiode des Quarzoszillators VCO.

Als Temperaturregler, der wie der phasenregler als PI-Regler ausgelegt ist, ermittelt der Mikroprozessor MP aus dem ihm von dem Phasenvergleicher her zugeführten Phasendiffrenzwert durch Differenzieren die Frequenzdifferenz, die ein Maß für die Temperatur ist. Aus dieser Frequenzdifferenz wird anschließend der Proportional- und Integralanteil ermittelt und eine entsprechende Stellgröße für die Regelung der Leistung des Heiztransistors, der in Fig. 2 mit HT bezeichnet ist, ausgegeben. Durch eine gegenüber der Zeitkonstanten der Thermostatanordnung große, für das Integralverhalten bestimmende Zeitkonstante wird eine Schwingneigung des Regelkreises verhindert. Der Integralanteil bewirkt, daß der Reoelfehler im gesamten Arbeits-Temperaturbereich im Mittel Null ist.

Der Mikroprozessor erhält für die Ermittlung der Stellgröße für die Regelung der Leistung des Heiztransistors HT zusätzlich eine Führungsgröße zugeführt. Der Wert dieser Führungsgröße entspricht dabei dem Temperatur-Umkehrpunkt des Quarzoszillators VCO und ist in einem nichtflüchtigen Schreib-/Lese-Speicher EEPRDM gespeichert. Der Wert der Führungsgröße steht demzufolge auch nach einem Stromversorgungsausfall wieder zur Verfügung. Den Temperatur-Umkehrpunkt ermittelt der Mikroprozessor dabei selbsttätig während eines Eichvorganges im Prüffeld. Bei diesem Vorgang wird an den Frequenzteiler FT3 ein Signal mit einer Normalfrequenz angeschaltet und mit dem beschriebenen Vergleicher die Phasendifferenz zwischen dieser Normalfrequenz und der Frequenz des Quarzoszillators VCO gemessen. Daraus ermittelt der Mikroprozessor die Phasendifferenz und deren Ableitung nach der Temperatur. Hierfür wird während des Eichvorganges die Temperatur des Thermostatgehäuses variiert. Auf diese Weise wird der Temperatur-Umkehrpunkt des Schwingquarzes ermittelt, bei dem der Temperaturkoeffizient Null ist. Dieser Temperatur-Umkehrpunkt wird, wie bereits oben erwähnt, in dem nichtflüchtigen Schreib-/Lese-Speicher gespeichert.

Für die Abgabe der für den Quarzoszillator VCO ermittelten Stellgröße ist der Mikroprozessor MP über den bereits erwähnten Datenbus DB mit einem Digital-/Analog-Wandler D/A1 verbunden. Dieser Digital-/Analog-Wandler gibt eine Analogspannung an die bereits genannte Varaktordiode des Quarzoszillators VCO ab. In Fig. 2 ist die Beschaltung des genannten Quarzoszillators mit der Varaktordiode schematisch dargestellt. Außerdem ist der zu dem Quarzoszillator gehörende Schwingquarz Q1 angedeutet.

Mit dem MikroProzessor MP ist über den bereits genannten Datenbus ein weiterer Digital-/Analog-Wandler D/A2 verbunden. Dieser Digital-/Analog-Wandler ist mit seinem analogen Ausgang an eine im Resonanzkreis des Hilfsoszillators TCO sich befindende Varaktordiode angeschlossen. Der Resonanzkreis mit dem Temperatur-Meßquarz Q2 und der Varaktordiode ist in Fig. 2 schematisch dargestellt.

Bei einem ersten Ausführungsbeispiel wird dem Hilfsoszillator TCO über den gerade genannten Digital-/Analog-Wandler D/A2 während des Betriebes des Frequenzgenerators in periodischen Abständen eine Stellgröße zugeführt. Die jeweils zugeführte Stellgröße ist dabei so festgelegt, daß der Hilfsoszillator auf einer lediglich durch die Innentemperatur des Thermostatgehäuses TG vorgegebenen Frequenz schwingt. Mit dieser Frequenz, die ein Maß für die in dem Thermostatgehäuse herrschende Innentemperatur ist, ist gleichzeitig der Arbeitspunkt des Quarzoszillators VCO festgelegt. Dieser Arbeitspunkt soll, wie vorstehend bereits erläutert worden ist, im Temperatur-Umkehrpunkt des Quarzoszillators liegen. In diesem Temperatur-Umkehrpunkt besteht eine feste Beziehung zwischen Temperaturänderung und der Differenz zwischen der von dem Quarzoszillator bereitgestellten Bezugsfrequenz und der Frequenz des Hilfsoszillators. Werden während des Betriebes des Frequenzgenerators Unregelmäßigkeiten in dieser Beziehung festgestellt, wie es beispielsweise bei einer Verschiebung des Arbeitspunktes aufgrund eines geänderten Schwingungsverhaltens des Hilfsoszillators der Fall sein kann, so wird durch eine entsprechend gewählte Stellgröße eine Frequenz des Hilfsoszillators eingestellt, die die Verschiebung des Arbeitspunktes kompensiert.

Bei einem zweiten Ausführungsbeispiel ermittelt der Mikroprozessor MP während eines Eichvorganges, der sich an die Festlegung des Temperatur-Umkehrpunktes des Quarzoszillators VCO anschließt, eine Abgleichgröße für den Hilfsoszillator TCO, mit der sich eine dem zuvor ermittelten Temperatur-Umkehrpunkt entsprechende Temperatur in dem Thermostatgehäuse einstellt. Durch diese Abgleichgröße kann die Frequenz des Hilfsoszillators als Maß für die Innentemperatur des Thermostatgehäuses in vorgegebenen Grenzen abgeolichen werden. Insbesondere werden durch die ermittelte Abgleichgröße durch Exemplarstreuungen des verwendeten Temperatur-Meßquarzes sich einstellende Frequenzabweichungen eliminiert. Die während des Eichvorganges ermittelte Abgleichgröße wird dem Hilfsoszillator dann während des Betriebes des Frequenzgenerators unverändert zugeführt. Damit sind Regelvorgänge zur Einstellung der Frequenz des Hilfsoszillators während des Betriebes des Frequenzgenerators nicht erforderlich. Die Frequenzkonstanz kann zwar unter Umständen bei einer Änderung des Schwingungsverhaltens des Hilfoszillators während des Betriebes des Frequenzgenerators etwas niedriger sein als die des Frequenzgenerator gemäß dem ersten Ausführungsbeispiel. Die erzielbare Frequenzkonstanz ist aber auf jeden Fall höher als die Frequenzkonstanz bei herkömmlichen Frequenzgeneratoren.

Während des zuletzt genannten Eichvorganges stellt der Mikroprozessor MP den dem Hilfsoszillator TCO nachgeschalteten Frequenzteiler FT2 ein, dessen Teilungsverhältnis variabel ist. Durch diese Einstellung wird erreicht, daß sich am Eingang des in Fig. 2 dargestellten Phasenvergleichers PV eine geeignete Frequenz für den Vergleich mit der durch den Frequenzteiler FTI um einen vorgegebenen Betrag verminderten Frequenz des Quarzoszillators VCO einstellt.

Auch der bereits erwähnte Frequenzteiler FT3 ist als Frequenzteiler mit einem variablen Teilungsverhältnis ausgelegt. Damit ist es möglich, den Frequenzgenerator mit unterschiedlichen Referenzfrequenzen RF zu betreiben. Der Abgleich des Frequenzteilers FT3 erfolgt dabei ebenfalls während des gerade erwähnten Eichvorganges.

Die gerade genannten Einstellungen der Frequenzteiler FT2 und FT3 bleiben während des Betriebes des Frequenzgenerators erhalten.

In Fig. 2 ist noch eine Digital-/Analog-Wandleranordnung dargestellt, die die von dem Mikroprozessor MP errechnete Stellgröße für die von dem Heiztransistor, in Fig. 2 mit HT bezeichnet, abzugebende Heizleistung zugeführt erhält. Diese Digital-/Analog-Wandleranordnung weist eine Zähleranordnung Z auf, welche mit ihren Setzeingängen für die Einstellung eines Anfangszählerstandes mit den die niederwertigen Bits D0 bis D7 führenden Leitungen des aus 16 Einzelleitungen bestehenden Datenbusses DB verbunden ist. Die die höherwertigen Bits D8 bis D15 führenden Leitungen des Datenbusses DB sind an erste Eingänge eines Addierers ADD angeschlossen. Ein weiterer als Überlauf-Eingang dienender Eingang dieses Addierers ist an den Zählerausgang der Zähleranordnung Z angeschlossen. Ausgangsseitig steht dieser Addierer ADD über eine aus acht Leitungen bestehende Leitungsanordnung mit einem Digital-/Analog-Wandler D/A3 in Verbindung. Diesem Digital-/Analog-Wandler ist eine im folgenden noch zu erläuternde Vergleicherschaltung nachgeschaltet, die die von dem Digital-/Analog-Wandler D/A3 abgegebene analoge Stellgröße dem in dem Thermostatgehäuse sich befindenden Heiztransistor zuführt.

Die Umsetzung der der gerade beschriebenen Digital-/Analog-Wandleranordnung zugeführten digitalen Stellgröße geht nun folgendermaßen vor sich. Die Zähleranordnung Z, bei der es sich um einen Rückwärtszähler handeln möge, übernimmt aufgrund eines von dem Mikroprozessor MP in periodischen Abständen wiederholt abgegebenen Steuersignals die acht niederwertigen Bits D0 bis D7 der von dem Mikroprozessor abgegebenen Datenbits D0 bis D15 als Anfangszählerstand. Die höherwertigen Bits D8 bis D15 werden, wie bereits oben erwähnt, dem Addierer ADD zugeführt. Nach der Einstellung des Anfangszählerstandes erhält die Zähleranordnung Z von einem Taktgenerator Taktsignale T zugeführt, welche einen Zählvorgang bis zum Erreichen eines vorgegebenen Endzählerstandes "0" auslösen. Vor dem Erreichen dieses Endzählerstandes gibt die Zähleranordnung Z an ihrem Ausgang einen logischen pegel "1" ab. Dieser pegel, der dem Überlauf-Eingang des Addierers ADD zugeführt wird, bewirkt, daß das niederwertigste Bit der dem Addierer ADD zugeführten Bits D8 bis D15 inkrementiert wird. Damit stellt der Addierer zunächst an seinem Ausgang ein Summensignal bereit, welches die auf den Wert D8 bis D15 aufgerundete digitale Stellgröße D0 bis D15 darstellt.

Nach Erreichen des Endzählerstandes "0" bis zur erneuten Einstellung eines Anfangszählerstandes wechselt der logische Pegel am Ausgang der Zähleranordnung Z, d.h. es stellt sich ein logischer Pegel "0" ein. Dieser Pegel bewirkt ein Dekrementieren des niederwertigsten Bits D8 des von dem Addierer ADD abgegebenen Summensignals. Dieses Dekrementieren entspricht damit einem Abrunden der von dem Mikroprozessor MP abgegebenen digitalen Stellgröße D0 bis D15 auf den Wert D8 bis D15.

Wie gerade erläutert, ist der ZeitPunkt des Pegelwechsels am Ausgang der Zähleranordnung Z während eines durch die Abgabe zweier aufeinanderfolgender Steuersignale für die Einstellung des Anfangszählerstandes der Zähleranordnung Z festgelegten Zeitintervalls durch die niederwertigsten Bits der von dem Mikroprozessor jeweils bereitgestellten Bits der digitalen Stellgröße festgelegt. Die Zähleranordnung Z gibt damit an ihrem Ausgang nach Maßgabe der ihr von dem Mikroprozessor her zugeführten Bits eine pulslängenmodulierte Impulsfolge ab, die das erwähnte Summensignal am Ausgang des Addierers ADD in der dargestellten Weise beeinflußt.

Die in zeitlicher Folge von dem Addierer ADD bereitgestellten Summensignale werden mit Hilfe des diesem Addierer nachgeschalteten Digital-/Analog-Wandlers D/A3 in analoge Signale umgesetzt. Der Wert eines solchen analogen Signals ändert sich dabei während eines durch das Auftreten zweier aufeinanderfolgender, von dem Mikroprozessor her abgegebener Steuersignale festgelegten Zeitintervalls. Der Zeitpunkt dieser Änderung ist, wie vorstehend gerade erläutert worden ist, durch den Zeitpunkt des Erreichens des Endzählerstandes der Zähleranordnung Z festgelegt. Entsprechend der zeitlichen Änderung des analogen Signals innerhalb des angegebenen Zeitintervalls gibt der dem Digital-/Analog-Wandler D/A3 nachgeschaltete Heiztransistor eine über dieses Zeitintervall gemittelte Heizleistung an das Thermostatgehäuse ab.

Bezüglich der erwähnten Zähleranordnung Z sei darauf hingewiesen, daß als Zähler auch ein Vorwärtszähler verwendet werden kann. In diesem Fall ist diesem Zähler jeweils das Komplement der niederwertigen Bits D0 bis D7 als Anfangszählerstand zuzuführen. Der Endzählerstand, der ein Wechsel des von der Zähleranordnung Z abgegebenen Pegels bewirkt, ist das Maximum der mit dieser Zähleranordnung erreichbaren Zählerstände. Vor Erreichen dieses Endzählerstandes gibt die Zähleranordnung Z zunächst an ihrem Ausgang einen logischen pegel "0" ab. Damit ist die von dem Mikroprozessor MP her abgegebene digitale Stellgröße D0 bis D15 auf einen Wert D8 bis D15 abgerundet. Nach Erreichen dieses Endzählerstandes, d.h. des Maximalzählerstandes, gibt dann die Zähleranordnung Z an ihrem Ausgang einen logischen Pegel "1" ab. Dieser logische Pegel bewirkt ein Inkrementieren des niederwertigsten Bits D8 des von dem Addierer ADD abgegebenen Summensignals. Dieses Inkrementieren entspricht damit einem Aufrunden der von dem Mikroprozessor abgegebenen digitalen Stellgröße D0 bis D15 auf den Wert D8 bis D15.

Ausgangsseitig ist der in Fig. 2 dargestellte Digital-/Analog-Wandler D/A3 an einen nichtinvertierenden Eingang eines als Vergleicherschaltung dienenden Operationsverstärkers (Differenzverstärkers) OP angeschlossen. Ein invertierender Eingang dieses Operationsverstärkers erhält von einem Multiplizierer MUL eine dem Produkt aus Heizspannung und Heizstrom entsprechende Vergleichsgröße zugeführt. Für die Ermittlung dieses produktes ist der Multiplizierer mit einem seiner Eingänge an den Emitter des Heiztransistors (HT) angeschlossen. Dieser Emitter ist über einen niederohmigen Widerstand R1 gegen Masse geschaltet. Auf diese Weise erhält der Multiplizierer MUL an dem erwähnten Eingang eine dem über den Heiztransistor fließenden Heizstrom proportionale Größe zugeführt.

Mit einem weiteren Eingang ist der gerade erwähnte Multiplizierer MUL mit einem Abgriff eines zwischen die Heizspannung Uh und Masse geschalteten Spannungsteilers R1, R2 verbunden. An diesem Abgriff ist damit eine der Heizspannung Uh proportionale Größe für den Multiplizierer MUL bereitgestellt.

An die gerade erwähnte Heizspannung Uh ist der Heiztransistor mit seinem Kollektor angeschlossen. Die Basis dieses Heiztransistors erhält das Ausgangssignal des bereits erwähnten Operaionsverstärkers OP zugeführt. Bei diesem Ausgangssignal handelt es sich um ein Stellsignal, welches dem Unterschied zwischen den mit Hilfe des Operationsverstärkers miteinander verglichenen Einganossignalen entspricht. Wie bereits erläutert, bestenen die Eingangssignale einerseits aus der von dem Mikroprozessor MP bereitgestellten und in dem Digital-/Analog-Wandler D/A3 umgesetzten Stellgröße und andererseits aus dem Ausgangssignal des Multiplizierers MUL.

Das Ausgangssignal des Multiplizierers MUL ändert sich bei Schwankungen der Heizspannung Uh und/oder des durch den Heiztransistor fließenden Heizstromes. Aufgrund dieses bei derartigen Schwankungen sich ändernden Ausgangssignals gibt der als Vergleicherschaltung dienende Operationsverstärker OP ein gegenüber der von dem Mikroprozessor bereitgestellten Stellgröße verändertes Stellsional dab. Dieses Stellsignal ist dabei so festgelegt, oaß der Heiztransistor stets die durch die genannte Stellgröße geforderte Heizleistung abgibt. Das bedeutet, daß bei einer Verringerung des von dem Multiplizierer MUL abgegebenen Ausgangssignals (Produkt aus Heizspannung und Heizstrom) ein gegenüber der von dem Mikroprozessor bereitgestellten Stellgröße größeres Stellsignal an die Basis des Heiztransistors abgegeben wird. Bei einer Vergrößerung des Ausgangssignals des Multiplizierers wird dagegen von dem Operationsverstärker OP ein Stellsignal bereitgestellt, welches gegenüber der gegenannten Stellgröße niedriger ist.

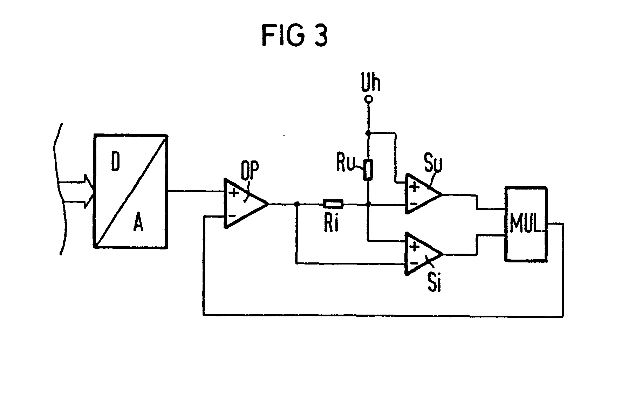

In Fig. 3 ist eine weitere Ausführungsform eines Heizelementes und der mit diesem verbundenen Vergleicherschaltung dargestellt. Als Heizelement ist hier anstelle eines Heiztransistors ein ohmscher Widerstand Ru vorgesehen, welcher einerseits mit einem Anschluß der Heizspannung Uh und andererseits über einen im Vergleich zu ihm niederohmigen Widerstand Ri mit dem Ausgang des bereits erwähnten Operationsverstärkers OP verbunden ist. Dieser Dperationsverstärker ist in Fig. 3 nochmals dargestellt. Der an dem ohmschen Widerstand Ru auftretende Spannungsabfall wird Eingängen eines Spannungssensors Su zugeführt. Dieser Spannungssensor ist aus einem Operationsverstärker (Differenzverstärker) mit einem nichtinvertierenden und einem invertierenden Eingang gebildet.

Der an dem gegenüber dem Widerstand Ru niederohmigen Widerstand Ri auftretende Spannungsabfall wird Eingängen eines Stromsensors Si zugeführt, bei welchem es sich ebenfalls um einen Operationsverstärker (Differenzverstärker) mit einem nichtinvertierenden und einem invertierenden Eingang handelt.

Die Ausgänge des Spannungssensors Su und des Stromsensors Si sind für die Abgabe einer der Heizspannung bzw. einer dem Heizstrom entsprechenden Größe mit den Eingängen des bereits erwähnten, in Fig. 3 nochmals dargestellten Multiplizierers MUL verbunden. Ausgangsseitig ist dieser Multiplizierer in der in Fig. 2 angegebenen Weise an den Operationsverstärker OP angeschlossen.

Mit dem Mikroprozessor MP ist über den Datenbus DB schließlich noch eine Rücksetzschaltung RS verbunden. Diese Rücksetzschaltung versetzt in bestimmten Betriebsfällen, wie z.B. beim Einschalten des Frequenzgenerators, die Frequenzteiler in eine definierte Bezugslage zu einem Vergleichstakt TO. Diese Rücksetzschaltung weist für jeden der Frequenzteiler FT2 und FT3 eine Schaltungsanordnung auf, wie sie in Fig. 4 schematisch dargestellt ist. Diese Schaltungsanordnungen werden jeweils über Ausgabeleitungen des Mikroprozessors aktiviert. Wie in Fig. 4 dargestellt, enthält jede dieser Schaltungsanordnungen zwei Kippstufen, in denen der von dem Mikroprozessor abgegebene Rücksetzbefehl W (WRITE) bis zu einem vorgegebenen Zeitpunkt gespeichert und nach Ausführung automatisch gelöscht wird. In Fig. 4 sind außerdem die Ausgangssignale der beiden Kippstufen sowie die Vergleichsfrequenz TO und die von dem jeweiligen Frequenzteiler abgegebene Frequenz Tx dargestellt.

## Patentansprüche

1. Anordnung zur Stabilisierung der von einem Frequenzgenerator (VCO), insbesondere einem Quarzgenerator, abgegebenen Frequenz, mit einer die frequenzbestimmenden Elemente dieses Frequenzgenerators auf einer vorgegebenen Temperatur haltenden Thermostatanordnung, welche aus einem die frequenzbestimmenden Elemente aufnehmenden Thermostatgehäuse und einem die Innentemperatur dieses Thermostatgehäuses regelnden Temperaturregler besteht, der ein Heizelement (HT) und einen als temperaturabhängigen Hilfsoszillator (TCO) ausgebildeten Temperatur-Sensor aufweist, dessen Frequenz für die Bereitstellung einer dem Heizelement zuzuführenden Stellgröße herangezogen ist, wobei die frequenzbestimmenden Elemente des Hilfsoszillators ebenfalls in dem Thermostatgehäuse aufgenommen sind und wobei die Temperaturabhängigkeit des Frequenzgenerators (VCO) und des Hilfsoszillators (TCO) zumindest innerhalb eines vorgegebenen Temperaturbereiches derart unterschiedlich ist, daß sich bei der gewünschten Frequenz des Frequenzgenerators ein stabiler Arbeitspunkt des aus dem Frequenzgenerator (VCO), dem Hilfsoszillator (TCO) und dem Heizelement (HT) bestehenden ersten Regelkreises einstellt, dadurch gekennzeichnet, daß der Hilfsoszillator (TCO) in einen ersten Phasenregelkreis (PH2, R2, TCO, FT2) einbezogen ist, durch welchen die Frequenz des Hilfsoszillators im Zuge eines Eichvorganges durch Zuführen einer entsprechenden Abgleichgröße nach Maßgabe einer Bezugsfrequenz auf den stabilen Arbeitspunkt des ersten Regelkreises regelbar ist.

2. Anordnung nach Anspruch 1, dadurch gekennzeichnet, daß die Frequenz des Hilfsoszillators (TCO) während des Betriebs bei einer Verschiebung des Arbeitspunktes des ersten Regelkreises nachregelbar ist.

3. Anordnung nach Anspruch 1 oder 2, dadurch gekennzeichnet, daß die genannte Bezugsfrequenz durch die Ausgangsfrequenz des Frequenzgenerators (VCO) gebildet ist.

4. Anordnung nach einem der Ansprüche 1 bis 3, dadurch gekennzeichnet, daß der Frequenzgenerator (VCO) in einen zweiten Phasenregelkreis (PH1, R1, VCD, FT1) einbezogen ist, daß der Frequenzgenerator (VCO) und der Hilfsoszillator (TCO) als spannungsgesteuerte Oszillatorschaltungen ausgebildet sind, daß für den ersten und den zweiten Phasenregelkreis ein gemeinsamer digitaler Phasendiskriminator (PV) vorgesehen ist, der wahlweise in die beiden Phasenregelkreise einschaltbar ist, und daß die den beiden Phasenregelkreisen zugehörigen Phasenregler (R1, R2) durch eine einzige Mikroprozessoranordnung (MP) gebildet sind, die über Digital-/Analog-Wandler (D/A1, D/A2) die genannten spannungsgesteuerten Oszillatorschaltungen jeweils mit einer Steuerspannung beaufschlagt.

5. Anordnung nach Anspruch 4, dadurch gekennzeichnet, daß das Heizelement (HT) über einen weiteren Digital-/Analog-Wandler (D/A3) mit der Mikroprozessoranordnung (MP) verbunden ist, welcher eine gegenüber der vorgegebenen Anzahl von Bits des von der Mikroprozessoranordnung bereitgestellten Signals geringere Anzahl von Signaleingängen aufweist, daß diese Signaleingänge mit dem Ausgang eines ein Summensignal abgebenden Addierers (ADD) verbunden sind, welcher an ersten Eingängen, deren Anzahl der Anzahl der Signaleingänge des Digital-/Analog-Wandlers (D/A3) entspricht, lediglich die höherwertigen Bits der von der Mikroprozessoranordnung bereitgestellten Bits zugeführt erhält und welcher mit einem weiteren Eingang an eine Steueranordnung (Z) angeschlossen ist, und daß diese Steueranordnung von den niederwertigen Bits der von der Mikroprozessoranordnung bereitgestellten Bits beaufschlagt ist und ein nach Maßgabe dieser niederwertigen Bits pulslängenmoduliertes Signal abgibt, welches während der Dauer seines Auftretens das niederwertigste Bit des von dem Addierer abgegebenen Summensignals beeinflußt.

6. Anordnung nach Anspruch 5, dadurch gekennzeichnet, daß die Steueranordnung aus einer taktgesteuerten Zähleranordnung (Z) gebildet ist, welche die niederwertigsten Bits der von der Mikroprozessoranordnung (MP) bereitgestellten Bits für die Einstellung eines Anfangszählerstandes zugeführt erhält und welche zunächst an ihrem Ausgang ein Signal mit einem ersten Binärwert abgibt, während sie bei Erreichen eines vorgegebenen Endzählerstandes bis zur erneuten Einstellung eines Anfangszählerstandes den zweiten Binärwert des Signals abgibt.

7. Anordnung nach Anspruch 5 oder 6, dadurch gekennzeichnet, daß das Heizelement (HT) am Ausgang einer Vergleicherschaltung (OP) angeschlossen ist, welche die von dem weiteren Digital-/Analog-Wandler (D/A3) her bereitgestellte Stellgröße mit einer dem Produkt aus Heizspannung und Heizstrom entsprechenden Größe vergleicht und ein solches dem Unterschied zwischen den beiden miteinander verglichenen Größen entsprechendes Stellsignal bereitstellt, daß das Heizelement stets die durch die genannte Stellgröße geforderte Heizleistung abgibt.

8. Anordnung nach Anspruch 7, dadurch gekennzeichnet, daß die Vergleicherschaltung (OP) eine Verstärkeranordnung aufweist, deren einer Eingang mit der die Temperaturregelung bewirkenden Stellgröße und deren anderer Eingang mit dem Produkt aus Heizspannung und Heizstrom beaufschlagt ist, und daß dem Heizelement (HT) eine dem Heizstrom und der Heizspannung jeweils proportionale Größe entnehmbar ist, welche ein mit seinem Ausgang an dem genannten anderen Eingang der Vergleicherschaltung angeschlossener Multiplizierer (MUL) zugeführt erhält.

9. Anordnung nach Anspruch 8, dadurch gekennzeichnet, daß das Heizelement (HT) aus einem Transitor gebildet ist, in dessen Kollektorzweig eine der Heizspannung und an dessen Emitteranschluß eine dem Heizstrom proportionale Größe entnehmbar ist.

10. Anordnung nach Anspruch 8, dadurch gekennzeichnet, daß das Heizelement (HT) aus einem ohmschen Widerstand (Ru) gebildet ist, daß die an dem Widerstand auftretende Spannung Eingängen eines Spannungssensors (Su) zugeführt ist, an dessen Ausgang eine der Heizspannung proportionale Größe auftritt, daß mit dem ohmschen Widerstand (Ru) ein weiterer, gegenüber diesem niederohmiger Widerstand (Ri) in Reihe geschaltet ist, und daß die an den Anschlüssen dieses weiteren Widerstandes auftretende Spannung Eingängen eines Stromsensors (Si) zugeführt ist, an dessen Ausgang eine dem Heizstrom proportionale Größe auftritt.

11. Anordnung nach einem der Ansprüche 8 bis 10, dadurch gekennzeichnet, daß die Vergleicherschaltung (OP), der Spannungssensor (Su) und der Stromsensor (Si) jeweils aus einem Differenzverstärker gebildet sind.

**Revendications**

1. Dispositif pour stabiliser la fréquence délivrée par un générateur de fréquence (VCO), notamment un générateur à quartz, comportant un dispositif à thermostat, qui maintient les éléments de ce générateur de fréquence, qui déterminent la fréquence, à une température prédéterminée et qui est constitué par un boîtier logeant les éléments déterminant la fréquence et par un régulateur de température, qui règle la température intérieure de ce thermostat et qui possède un élément chauffant (HT) et un capteur de température réalisé sous la forme d'un oscillateur auxiliaire (TCO), qui dépend de la température et dont la fréquence est utilisée pour préparer une grandeur de réglage devant être envoyée à l'élément chauffant, et dans lequel les éléments, de l'oscillateur auxiliaire, qui déterminent la fréquence, sont également logés dans le boîtier du thermostat, et la dépendance du générateur de fréquence (VCO) vis-à-vis de la température et la dépendance de l'oscillateur auxiliaire (TCO) vis-à-vis de la température diffèrent, au moins à l'intérieur d'une plage prédéterminée de températures, de telle sorte que, pour la fréquence désirée du générateur de fréquence, il s'établit un point de fonctionnement stable du premier circuit de régulation constitué par le générateur de fréquence (VCO), l'oscillateur auxiliaire (TCO) et l'élément chauffant (HT), caractérisé par le fait que l'oscillateur auxiliaire (TCO) est inséré dans un premier circuit (PH2, R2, TCO, FT2) de régulation de la phase, à l'aide duquel la fréquence de l'oscillateur auxiliaire peut être réglée sur le point de fonctionnement stable du premier circuit de régulation, en fonction d'un processus d'étalonnage, au moyen de l'envoi d'une grandeur d'équilibrage correspondante en fonction d'une fréquence de référence.

2. Dispositif suivant la revendication 1, caractérisé par le fait que la fréquence de l'oscillateur auxiliaire (TCO) peut faire l'objet d'un réglage complémentaire pendant le fonctionnement, dans le cas d'un décalage du point de fonctionnement du premier circuit de régulation.

3. Dispositif suivant la revendication 1 ou 2, caractérisé par le fait que ladite fréquence de référence est formée par la fréquence de sortie du générateur de fréquence (VCO).

4. Dispositif suivant l'une des revendications 1 à 3, caractérisé par le fait que le générateur de fréquence (VCO) est inséré dans un second circuit de régulation de phase (PH1, R1, VCO, FT1), que le générateur de fréquence (VCO) et l'oscillateur auxiliaire (TCO) sont réalisés sous la forme de circuits oscillateurs commandés par la tension, qu'il est prévu, pour les premier et second circuits de régulation de phase, un discriminateur de phase numérique commun (PV), qui peut être branché au choix dans les deux circuits de régulation de phase, et que les régulateurs de phase (R1, R2) associés aux deux circuits de régulation de phase sont formés par un seul dispositif à microprocesseur (MP), qui applique respectivement une tension de commande auxdits circuits oscillateurs commandés par la tension, par l'intermédiaire de convertisseurs numérique/analogique (D/A1, D/A2).

5. Dispositif suivant la revendication 4, caractérisé par le fait que l'élément chauffant (HT) est relié par l'intermédiaire d'un autre convertisseur numérique/analogique (D/A3) au dispositif à microprocesseur (MP), qui comporte un nombre d'entrées de signaux, inférieur au nombre prédéterminé de bits du signal préparé par le dispositif à microprocesseur, que ces entrées des signaux sont reliés à la sortie d'un additionneur (ADD), qui délivre un signal somme et reçoit uniquement des bits de poids supérieur faisant partie des bits préparés par le dispositif à microprocesseur, au niveau de premières entrées, dont le nombre correspond aux entrées des signaux du convertisseur numérique/analogique (D/A3), et est raccordé par une autre entrée à un dispositif de commande (Z), et que ce dispositif de commande est chargé par les bits de poids inférieur faisant partie des bits préparés par le dispositif à microprocesseur et délivre un signal, dont la durée des impulsions est modulée en fonction de ces bits de poids inférieur et qui influe, pendant la durée de son apparition, sur le bit de poids le plus faible du signal somme délivré par l'additionneur.

6. Dispositif suivant la revendication 5, caractérisé par le fait que le dispositif de commande (Z) comporte d'un dispositif de comptage (Z) commandé de façon cadencée, qui reçoit les bits de poids les plus faibles faisant partie des bits préparés par le dispositif à microprocesseur (MP), pour le réglage d'un état initial du compteur et délivre tout d'abord, sur sa sortie, un signal possédant une première valeur binaire, tandis que, lorsqu'un état final de comptage est atteint, il délivre la seconde valeur binaire, jusqu'au nouveau réglage d'un état initial du compteur.

7. Dispositif suivant la revendication 5 ou 6, caractérisé par le fait que l'élément chauffant (HT) est raccordé à la sortie d'un circuit comparateur (OP), qui compare la grandeur de réglage, préparée à partir de l'autre convertisseur numérique/analogique (D/A3), à une grandeur correspondant au produit de la tension de chauffage par le courant de chauffage et prépare un signal de réglage, qui correspond à la différence entre les deux grandeurs comparées entre elles et est tel que l'élément chauffant délivre en permanence la puissance de chauffage demandée par ladite grandeur de réglage.

8. Dispositif suivant la revendication 7, caractérisé par le fait que le circuit comparateur (OP) possède un dispositif amplificateur, dont une entrée est chargée par la grandeur de réglage réalisant la régulation de température et dont l'autre entrée est chargée par le produit de la tension de chauffage par le courant de chauffage, et que sur l'élément chauffant (HT) peut être prélevée une grandeur, qui est respectivement proportionnelle au courant de chauffage et à la tension de chauffage et est envoyée à un multiplicateur (MUL), dont la sortie est raccordée à ladite autre entrée du circuit comparateur.

9. Dispositif suivant la revendication 8, caractérisé par le fait que l'élément chauffant (HT) est formé par un transistor, dans la branche du collecteur duquel peut être prélevée une grandeur proportionnelle à la tension de chauffage, tandis que sur sa borne d'émetteur peut être prélevée une grandeur proportionnelle au courant de chauffage.

10. Dispositif suivant la revendication 8, caractérisé par le fait que l'élément chauffant (HT) est formé par une résistance ohmique (Ru), que la tension apparaissant aux bornes de la résistance est envoyée aux entrées d'un détecteur de tension (Su), à la sortie duquel apparaît une grandeur proportionnelle à la tension de chauffage, qu'en série avec la résistance ohmique (Ru) est branchée une autre résistance (Ri) possédant une valeur ohmique inférieure à celle de l'autre résistance, et que la tension apparaissant aux bornes de cette autre résistance est envoyée aux entrées d'un détecteur de courant (Si), à la sortie duquel apparaît une grandeur proportionnelle au courant de chauffage.

11. Dispositif selon l'une des revendications 8 à 10, caractérisé par le fait que le circuit comparateur (OP), le détecteur de tension (Su) et le détecteur de courant (Si) sont constitués respectivement par un amplificateur différentiel.

**Claims**

1. Arrangement for the stabilization of the frequency emitted by a frequency generator (VCO), in particular by a quartz generator, having a thermostat arrangement which keeps the frequency-determining elements of this frequency generator at a predetermined temperature, which thermostat arrangement consists of a thermostat housing which receives the frequency-determining elements and of a temperature controller which controls the internal temperature of this thermostat housing, which temperature controller has a heating element (HT) and a temperature sensor constructed as temperature-dependant frequency-change oscillator (TCO), the frequency of which temperature sensor is used for providing a control variable to be fed to the heating element, the frequency-determining elements of the frequency-change oscillator being likewise received in the thermostat housing and the temperature dependency of the frequency generator (VCO) and of the frequency-change oscillator (TCO) being, at least within a predetermined temperature range, varied to such an extent that, at the desired frequency of the frequency generator, a stable operating point of the first control circuit consisting of the frequency generator (VCO), the frequency-change oscillator (TCO) and the heating element (HT) arises, characterized in that the frequency-change oscillator (TCO) is included in a first phase-locked loop (PH2, R2, TCO, FT2), by means of which the frequency of the frequency-change oscillator can be controlled in the course of a calibration procedure by feeding a corresponding tuning variable according to a reference frequency to the stable operating point of the first control circuit.

2. Arrangement according to Claim 1, characterized in that the frequency of the frequency-change oscillator (TCO) can be subsequently controlled during the operation by displacing the operating point of the first control circuit.

3. Arrangement according to Claim 1 or 2, characterized in that the mentioned reference frequency is formed by the output frequency of the frequency generator (VCO).

4. Arrangement according to one of Claims 1 to 3, characterized in that the frequency generator (VCO) is included in a second phase-locked loop (PH1, R1, VCO, FT1), in that the frequency generator (VCO) and the frequency-change oscillator (TCO) are formed as voltage-controlled oscillator circuits, in that, for the first and the second phase-locked loop, a common digital phase discriminator (PV) is provided which can be optionally connected to the two phase-locked loops, and in that the phase controllers (R1, R2) belonging to the two phase-locked loops are formed by a single microprocessor arrangement (MP) which applies, via digital-analog convertors (D/A1, D/A2), in each case a control voltage to the mentioned voltage-controlled oscillator circuits.

5. Arrangement according to Claim 4, characterized in that the heating element (HT) is connected via a further digital-analog convertor (D/A3) to the microprocessor arrangement (MP) which, in relation to the predetermined number of bits of the signal made available by the microprocessor arrangement, has a lower number of signal inputs, in that these signal inputs are connected to the output of an adder (ADD) which emits a composite signal, which adder has fed to it, at first inputs the number of which corresponds to the number of signal inputs of the digital-analog convertor (D/A3), only the high-order bits of the bits made available by the microprocessor arrangement and which adder is connected by a further input to a control arrangement (Z), and in that this control arrangement is applied by the low-order bits of the bits made available by the microprocessor arrangement and emits a pulse-length modulated signal in accordance with these low-order bits, which signal, during the duration of the bits occurrence, effects the least significant bit of the composite signal emitted by the adder.

6. Arrangement according to Claim 5, characterized in that the control arrangement is formed from a clock-controlled counter arrangement (Z) which has fed to it the least significant bits of the bits made available by the microprocessor arrangement (MP) for setting an initial counter state and which emits, initially at its output, a signal with a first binary value, while, on reaching a predetermined final counter state, it emits the second binary value of the signal until the resetting of an initial counter state.

7. Arrangement according to Claim 5 or 6, characterized in that the heating element (HT) is connected to the output of a comparator circuit (OP) which compares the control variable made available by the further digital-analog convertor (D/A3) with a variable corresponding to the product of the heating voltage and heating current and produces such a control signal corresponding to the difference between the two compared variables that the heating element constantly emits the heating power required by the mentioned control variable.

8. Arrangement according to Claim 7, characterized in that the comparator circuit (OP) has an amplifier arrangement, the one input of which has the control variable, which brings about the temperature control, applied to it and the other input of which has the product of the heating voltage and heating current applied to it, and in that, from the heating element (HT), a variable can be obtained which is proportional to the heating current and the heating voltage, which variable has fed to it a multiplier (MUL) connected by its output to the mentioned other input of the comparator circuit.

9. Arrangement according to Claim 8, characterized in that the heating element (HT) is formed from a transistor, it being possible to obtain at its collector branch a variable which is proportional to the heating voltage and to obtain at its emitter terminal a variable which is proportional to the heating current.

10. Arrangement according to Claim 8, characterized in that the heating element (HT) is formed from an ohmic resistor (Ru), in that the voltage occurring at the resistor is fed to inputs of a voltage sensor (Su), at the output of which a variable occurs which is proportional to the heating voltage, in that a further resistor (Ri) which is low-valued in relation to the ohmic resistor (Ru) is connected in series to the latter, and in that the voltage occurring at the terminals of this further resistor is fed to inputs of a current sensor (Si), at the output of which a variable occurs which is proportional to the heating current.

11. Arrangement according to one of Claims 8 to 10, characterized in that the comparator circuit (OP), the voltage sensor (Su) and the current sensor (Si) are in each case formed from a differential amplifier.

## FIG 1

## FIG 4

FIG 2

# FIG 3